Europäisches Patentamt

European Patent Office

Office européen des brevets

(11) Numéro de publication : **0 083 540**
**B1**

(12) **FASCICULE DE BREVET EUROPÉEN**

(45) Date de publication du fascicule du brevet :
**05.03.86**

(21) Numéro de dépôt : **82402377.4**

(22) Date de dépôt : **23.12.82**

(51) Int. Cl.⁴ : **C 30 B 19/10**, C 30 B 19/04,
C 30 B 29/40

(54) **Procédé de depôt par épitaxie en phase liquide d'un composé ternaire.**

(30) Priorité : **28.12.81 FR 8124291**

(43) Date de publication de la demande :
**13.07.83 Bulletin 83/28**

(45) Mention de la délivrance du brevet :
**05.03.86 Bulletin 86/10**

(84) Etats contractants désignés :
**DE GB NL**

(56) Documents cités :
**FR-A- 2 151 171**
**FR-A- 2 183 522**

(73) Titulaire : **Benchimol, Jean-Louis**
**5 rue Loredde**
**F-75013 Paris (FR)**

**Quillec, Maurice**
**17 rue Emile Dubois**
**F-75014 Paris (FR)**

(72) Inventeur : **Benchimol, Jean-Louis**
**5 rue Loredde**
**F-75013 Paris (FR)**
Inventeur : **Quillec, Maurice**
**17 rue Emile Dubois**
**F-75014 Paris (FR)**

(74) Mandataire : **Mongrédien, André et al**
**c/o BREVATOME 25, rue de Ponthieu**
**F-75008 Paris (FR)**

# 0 083 540

## Description

La présente invention a pour objet un procédé de dépôt par épitaxie en phase liquide d'un composé ternaire monocristallin de formule $A_xB_{n-x}C_m$ dans laquelle A, B et C sont des éléments de la classification périodique des éléments, n et m sont des nombres entiers et x est compris entre 0 et n.

Elle s'applique en particulier aux composés du type III-V ou du type II-VI, qui sont des composés de formule $A_xB_{1-x}C$ dans laquelle A, B et C sont des éléments appartenant aux groupes II, III, V et VI de la classification périodique des éléments et x est compris entre 0 et 1, avec A et B appartenant à un même groupe de la classification périodique et C appartenant à un groupe différent.

La plupart des composés de ce type présentent un grand intérêt en raison de leurs propriétés semiconductrices.

Parmi les procédés connus pour déposer des couches cristallines de composés ternaires de ce type, l'épitaxie en phase liquide est une technique largement utilisée, qui consiste à faire croître sur un substrat monocristallin une couche de matériau solide déposée à partir d'une phase liquide sursaturée. La composition du solide déposé sur le substrat dépend de la composition de la phase liquide sursaturée et de la température utilisée. Pour préparer le bain d'épitaxie, on commence par peser les quantités des différents constituants pour avoir la composition voulue, puis on porte le mélange de constituants à la température nécessaire pour former la phase liquide sursaturée. Ensuite, on met en contact le bain ainsi obtenu avec le substrat à revêtir en opérant soit à température constante, soit à température décroissante pour compenser les variations de composition du bain au cours de la croissance de la couche épitaxiée.

Pour la préparation de composés ternaires de formule $InAs_{1-x}Sb_x$ avec x compris entre 0 et 1, on connaît aussi un procédé de dépôt par épitaxie en phase liquide, selon lequel on prépare un bain d'épitaxie en pesant les quantités appropriées d'indium, d'antimoine et d'arséniure d'indium polycristallin et en chauffant ensuite le mélange ainsi obtenu à la température voulue pour dissoudre l'arséniure d'indium et saturer le bain ; on réalise ensuite le dépôt en introduisant dans le bain le substrat à revêtir et une source d'arséniure d'indium et en établissant un gradient de température entre la source de composé binaire InAs porté à la température $T_1$ et le substrat à revêtir porté à une température $T_2$ inférieure à $T_1$ (J. Electrochem. Soc. vol. 118, n° 5 (1971) p. 805-810). Ainsi, on s'assure que la phase liquide du bain est sous-saturée par rapport à la source de composé binaire InAs et qu'elle est sursaturée par rapport au substrat de croissance.

On peut ainsi faire croître la couche à température constante puisqu'on alimente la phase liquide en deux constituants du bain par dissolution de la source de composé binaire InAs, mais il est nécessaire d'établir pendant toute la durée de l'opération un gradient de température entre la source et le substrat de croissance.

Ces procédés connus présentent certains inconvénients :

la composition initiale du bain d'épitaxie doit être déterminée avec précision, ce qui implique un calcul et un contrôle rigoureux de la masse des différents constituants du bain,

la composition de la couche obtenue n'est pas homogène sur toute son épaisseur, ce qui impose certaines limitations sur l'épaisseur des couches déposées.

En effet, la composition du solide est généralement différente de celle de la phase liquide en équilibre avec lui ; en conséquence, la composition du bain d'épitaxie varie au cours de l'opération de dépôt et de ce fait il en est de même pour la composition du solide déposé. Toutefois, dans le cas de la préparation du composé $InAs_{1-x}Sb_x$ où l'on opère avec un excès du composé binaire InAs, on obtient une variation moins rapide de la composition du bain, et ceci permet l'obtention de couches plus épaisses avec un gradient plus faible de composition. Cependant, dans ce dernier cas, il est nécessaire d'utiliser un appareillage particulier pour établir dans le creuset d'épitaxie un gradient de température contrôlée, ce qui complique la mise en œuvre de l'épitaxie et rend ce procédé peu adapté pour une utilisation industrielle.

La présente invention a précisément pour objet un procédé d'épitaxie en phase liquide qui pallie les inconvénients des procédés connus.

Le procédé, selon l'invention pour déposer sur un substrat, par épitaxie en phase liquide, un composé ternaire, cristallisant dans le même système que le substrat et répondant à la formule $A_xB_{n-x}C_m$ dans laquelle A, B et C sont des éléments de la classification périodique des éléments, n et m sont des nombres entiers qui peuvent être identiques ou différents, et x est compris entre 0 et n, consiste à mettre en contact un bain d'épitaxie avec le substrat à revêtir, et à déposer sur celui-ci le composé ternaire $A_xB_{n-x}C_m$, caractérisé en ce que l'on prépare ledit bain d'épitaxie en portant l'un des éléments A ou B du composé ternaire et un excès du composé binaire solide stœchiométrique des deux autres éléments dudit composé ternaire à une température légèrement inférieure à celle du liquidus de la phase liquide de A, B et C en équilibre avec la phase solide $A_xB_{n-x}C_m$ et en ce que l'on effectue le dépôt à cette température.

Généralement n et m sont des nombres entiers allant de 1 à 3.

Le procédé de l'invention présente en particulier l'avantage de ne pas nécessiter un calcul précis et une pesée des masses de constituants à introduire dans le bain d'épitaxie.

En effet, le fait d'utiliser pour le dépôt un bain d'épitaxie ayant des concentrations en deux des éléments du composé ternaire $A_xB_{n-x}C_m$ qui correspondent aux concentrations de ces éléments dans le

2

composé binaire stœchiométrique, et le fait de réaliser le dépôt de la couche en présence d'un excès de ce composé binaire permet de simplifier les opérations préliminaires de préparation du bain car il suffit de porter à la température voulue l'un des éléments du composé ternaire en présence d'un excès du composé binaire pour obtenir la composition de bain voulue.

Selon l'invention, le composé binaire utilisé peut être un composé de B et de C ou un composé de A et de C.

Selon un premier mode de mise en œuvre du procédé de l'invention, le composé binaire est un composé de B et de C, et l'on prépare le bain d'épitaxie en portant l'élément A et le composé binaire solide stœchiométrique de formule $B_nC_m$ en excès à la température voulue.

Selon un second mode de mise en œuvre du procédé de l'invention, le composé binaire est un composé de A et de C, et l'on prépare le bain d'épitaxie en portant l'élément B et le composé binaire solide stœchiométrique de formule $A_nC_m$ en excès à la température voulue.

Dans les deux modes de mise en œuvre du procédé de l'invention, on contrôle la composition du bain d'épitaxie en agissant uniquement sur la température à laquelle on porte soit le mélange de B et du composé binaire $A_nC_m$, soit le mélange de A et du composé binaire $B_nC_m$.

Cette température est très voisine de la température de liquidus de la phase liquide de A, de B et de C ayant des concentrations en A et en C ou des concentrations en B et en C correspondant respectivement aux composés $A_nC_m$ ou $B_nC_m$, qui est en équilibre avec la phase solide $A_xB_{n-x}C_m$ ; la température de liquidus peut être déterminée à partir des diagrammes de phase du composé ternaire de A, de B et de C.

Ainsi, on obtient les températures de liquidus des phases liquides en équilibre avec $A_xB_{n-x}C_m$ et l'on vérifie ensuite expérimentalement ces températures.

Pour la mise en œuvre du procédé de l'invention, on prépare le bain d'épitaxie en portant le mélange de A et du composé binaire $B_nC_m$ ou le mélange de B et du composé binaire $A_nC_m$ à une température légèrement inférieure à la température de liquidus telle que déterminée précédemment. En effet, on a trouvé que lorsqu'on mettait en présence à une température T une phase liquide de A, de B et de C avec le composé binaire $A_nC_m$ ou $B_nC_m$, l'état final de la phase liquide était automatiquement un état de sursaturation. Aussi, pour obtenir la composition de phase liquide qui correspond à l'équilibre avec la phase solide $A_xB_{n-x}C_m$, il est nécessaire d'opérer à une température légèrement inférieure à la température de liquidus de cette phase liquide.

De plus, on peut tirer profit selon l'invention de cet état de sursaturation dû à la présence d'un excès du composé $A_nC_m$ ou $B_nC_m$, pour réaliser le dépôt par épitaxie en opérant à une température constante et uniforme.

En effet, pour le dépôt il n'est pas nécessaire d'établir un gradient thermique entre la source de composé binaire $A_nC_m$ ou $B_nC_m$ et le substrat à revêtir puisque l'on obtient automatiquement à une température inférieure à la température de liquidus, la sursaturation de la phase liquide en contact avec la source de composé binaire.

Aussi, on peut réaliser le dépôt sur le substrat en le portant à la même température que le bain d'épitaxie, c'est-à-dire à une température légèrement inférieure à la température de liquidus de la phase liquide de A, de B et de C qui correspond à l'équilibre avec la phase solide $A_xB_{n-x}C_m$.

Généralement, on opère à une température inférieure de quelques degrés à la température de liquidus. Le choix de cette température est déterminé à partir des données théoriques que l'on vérifie ensuite expérimentalement.

Le procédé de l'invention s'applique en particulier au dépôt par épitaxie en phase liquide de composés ternaires du type III-V, et du type II-VI. Cependant, on peut aussi l'utiliser pour le dépôt de composés du type IV-IV, du type III-VI, du type II-V, du type IV-VI et du type II-IV-VI.

A titre d'exemple de composés du type III-V, on peut citer les composés $Ga_xIn_{1-x}As$, $As_xSb_{1-x}Ga$, $As_xSb_{1-x}In$, $P_xSb_{1-x}In$ et $P_xSb_{1-x}Ga$.

De tels composés peuvent être préparés en utilisant différents substrats de dépôt adaptés au composé à préparer. Ainsi pour la fabrication de $Ga_xIn_{1-x}As$ en utilisant un bain d'épitaxie formé à partir de In et d'un excès de composé binaire GaAs, on peut utiliser comme substrat du InP. Lorsqu'on prépare le composé $As_xSb_{1-x}Ga$ en utilisant un bain obtenu à partir de Sb et d'un excès du composé GaAs, on peut utiliser un substrat en GaSb. On peut utiliser ce même substrat lorsqu'on prépare le composé $As_xSb_{1-x}In$ à partir d'un bain formé de Sb et d'un excès de InAs. Lorsqu'on prépare le composé $P_xSb_{1-x}In$ en utilisant un bain d'épitaxie formé à partir de Sb et du composé binaire InP, on peut utiliser un substrat en GaSb ou en InAs.

Enfin, lorsqu'on forme le composé ternaire $P_xSb_{1-x}Ga$ en utilisant un bain formé à partir de Sb et du composé binaire GaP, on peut utiliser comme substrat du GaAs ou du InP.

A titre d'exemple de composés du type II-VI susceptibles d'être utilisés, on peut citer les composés suivants :

$Zn_xCd_{1-x}Se$, $Zn_xCd_{1-x}Te$, $Zn_xHg_{1-x}Te$, $Zn_xHg_{1-x}Se$, $Cd_xHg_{1-x}Se$, $Cd_xHg_{1-x}Te$, $Zn_xCd_{1-x}S$, $Zn_xCd_{1-x}Se$, $Zn_xCd_{1-x}Te$, $Zn_xHg_{1-x}S$, $S_xSe_{1-x}Zn$, $S_xTe_{1-x}Zn$, $S_xSe_{1-x}Cd$, $S_xTe_{1-x}Cd$, $Se_xTe_{1-x}Zn$, $Se_xTe_{1-x}Cd$ et $Se_xTe_{1-x}Hg$.

Dans le tableau suivant, on a indiqué les constituants (composés binaires AB et solvants C) susceptibles d'être utilisés dans le bain d'épitaxie en vue d'obtenir les différents composés du type II-VI figurant dans les cases du tableau.

Tableau

Matériaux II-VI

| composé binaire (AB)  solvant (C) | ZnS | ZnSe | ZnTe | CdSe | CdTe | HgSe | HgTe |
|---|---|---|---|---|---|---|---|
| Zn | | | | $Zn_xCd_{1-x}Se$ | $Zn_xCd_{1-x}Te$ | $Zn_xHg_{1-x}Se$ | $Zn_xHg_{1-x}Te$ |
| Cd | $Zn_xCd_{1-x}S$ | $Zn_xCd_{1-x}Se$ | $Zn_xCd_{1-x}Te$ | | | $Cd_xHg_{1-x}Se$ | $Cd_xHg_{1-x}Te$ |
| Hg | $Zn_xHg_{1-x}S$ | $Zn_xHg_{1-x}Se$ | $Zn_xHg_{1-x}Te$ | $Cd_xHg_{1-x}Se$ | $Cd_xHg_{1-x}Te$ | | |
| S | | $S_xSe_{1-x}Zn$ | $S_xTe_{1-x}Zn$ | $S_xSe_{1-x}Cd$ | $S_xTe_{1-x}Cd$ | | |
| Se | $S_xSe_{1-x}Zn$ | | $Se_xTe_{1-x}Zn$ | | $Se_xTe_{1-x}Cd$ | | $Se_xTe_{1-x}Hg$ |
| Te | $S_xTe_{1-x}Zn$ | $Se_xTe_{1-x}Zn$ | | $Se_xTe_{1-x}Cd$ | | $Se_xTe_{1-x}Hg$ | |

0 083 540

A titre de composé du type IV-VI, on peut citer PbSnTe.

A titre d'exemple de composés des types II-IV-VI, on peut citer PbCdS et PbCdSe.

D'autres caractéristiques et avantages de l'invention apparaîtront mieux à la lecture de l'exemple suivant donné bien entendu à titre illustratif et non limitatif, en référence aux dessins annexés sur lesquels :

la figure 1 représente le diagramme ternaire des phases d'un système ternaire ABC

les figures 2a et 2b représentent schématiquement le creuset d'épitaxie, et

la figure 3 représente le profil de diffraction aux rayons X d'une couche de $In_{0,53}Ga_{0,47}As$ obtenue selon l'invention.

Cet exemple concerne le dépôt d'une couche de $In_{0,53}Ga_{0,47}As$ sur un substrat en InP.

Tout d'abord, on détermine à partir du diagramme de phase du système InGaAs la composition de la phase liquide InGaAs ayant la même concentration en Ga et As, qui est en équilibre avec le solide $In_{0,53}Ga_{0,47}As$ ainsi que la température de liquidus correspondante.

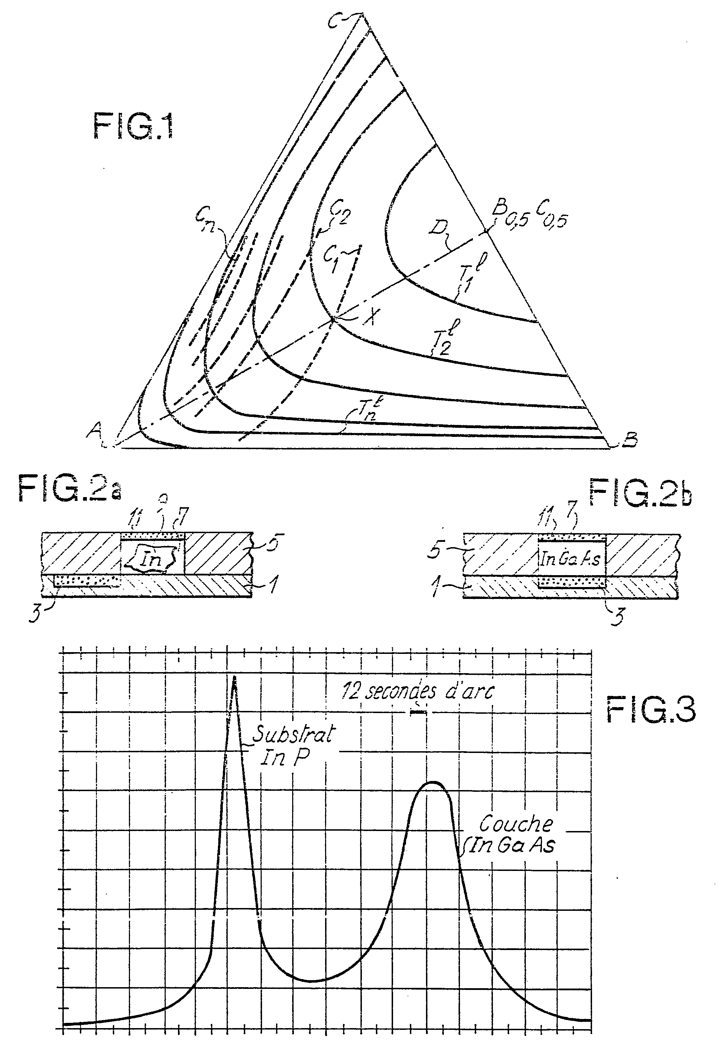

Sur la figure 1 annexée, on a représenté un diagramme ternaire illustrant, dans le cas d'un composé ternaire ABC, les différentes courbes utilisées pour déterminer la température de liquidus en vue d'obtenir un composé de formule $A_xB_{1-x}C$.

Sur ce diagramme, les courbes en traits pleins ou courbes de liquidus illustrent les compositions de phases liquides présentant la même température de liquidus $T_1^1$, $T_2^1...T_n^1$, les courbes en tirets ou courbes d'isosolidus représentant les compositions liquides en équilibre avec la même phase solide de composition $C_1$, $C_2...C_n$ et la courbe en traits mixtes D représente les compositions liquides ayant la même concentration en D et en C.

L'intersection au point X de la courbe de liquidus $T_2^1$ avec la courbe en traits mixtes D et la courbe d'isosolidus $C_1$, donne la température $T_2^1$ à laquelle on peut mettre en œuvre le procédé de l'invention pour obtenir par épitaxie le solide $A_xB_{1-x}C$ correspondant à la composition $C_1$. Seules les compositions solides correspondant à un tel point X seront accessibles à la croissance selon l'invention.

Dans le cas du système ternaire, InGaAs, on obtient une température de 505 °C pour l'obtention d'une phase solide $In_{0,53}Ga_{0,47}As$ lorsqu'on utilise un bain obtenu à partir de In et de GaAs orienté (100).

Lorsque le composé que l'on veut obtenir par épitaxie répond à la formule $A_xB_{n-x}C_m$ avec n # m, on détermine la température de liquidus de la même façon mais en utilisant, à la place de la courbe D, la courbe D' des compositions liquides dont le rapport des concentrations en B et en C reste égal à n/m.

Après avoir effectué cette détermination, on vérifie expérimentalement cette température de liquidus en utilisant la technique dite « à une phase ». Dans ce cas, on obtient la composition du liquide par pesée des constituants et on mesure la température de liquidus $T^1$ par visualisation directe en opérant dans un four semi-transparent. On analyse ensuite le solide épitaxié par diffraction aux rayons X ou par une microsonde électronique, et on réajuste la composition du liquide jusqu'à l'obtention de la phase solide $In_{0,53}Ga_{0,47}As$. On trouve ainsi que la température de liquidus est de 499 °C.

Après cette opération, on détermine le degré de sursaturation du bain liquide de In, Ga et As en présence d'un excès de composé binaire GaAs. Dans ce but, on met en présence de l'indium pur avec une plaquette de GaAs orienté (100) à une température de 500 °C, en réalisant la dissolution pendant une durée suffisamment longue (environ 1/2 h) pour obtenir une phase liquide homogène InGaAs ayant des concentrations égales en Ga et en As, avec un excès de GaAs.

On retire alors la plaquette de GaAs en excès de la phase liquide et on mesure ensuite la température de liquidus de la phase liquide ainsi obtenue par visualisation directe dans un four semi-transparent. On trouve ainsi qu'elle correspond à 504 °C. Ainsi, la phase liquide InGaAs mise en présence de GaAs est sursaturée de 4 °C. Aussi, pour obtenir par le procédé de l'invention un dépôt par épitaxie de $In_{0,53}Ga_{0,47}As$, on doit opérer à une température de 499 °C − 4 °C, soit à une température de 495 °C.

On réalise l'épitaxie dans un appareil d'épitaxie comportant un creuset en graphite placé dans un tube de quartz sous flux d'hydrogène. Comme représenté sur la figure 2a, le creuset comprend une partie fixe 1 comportant des logements tels que 3 dans lesquels on dispose le substrat de croissance en InP orienté (100) et une partie mobile en forme de tiroir 5 comportant des logements 7 dans lesquels on introduit un morceau d'indium 9 que l'on recouvre d'un substrat 11 de GaAs orienté (100). On chauffe alors le tube de quartz pour porter le morceau d'indium et le substrat de GaAs à une température de 495 °C et on maintient cette température pendant une demi-heure pour homogénéiser le bain. On contrôle la température du bain liquide au moyen d'un thermocouple disposé dans une canne de quartz servant au déplacement du tiroir 5. On déplace ensuite le tiroir 5 (figure 2b) de façon à amener le substrat de croissance 3 en InP sous le bain d'épitaxie 7 et on maintient la température à 495 °C. On obtient ainsi le dépôt d'une couche épitaxiée de 3 µm d'épaisseur en $In_{0,53}Ga_{0,47}As$ avec une vitesse de croissance de l'ordre de 0,1 µm/mn. Après dépôt, on contrôle les propriétés de la couche obtenue par diffraction aux rayons X sur les plans 400.

La figure 3 représente le profil de double diffraction obtenu. Sur cette figure, on voit que l'écart angulaire entre les pics associés à la couche épitaxiée et au substrat de InP correspond à un désaccord de mailles de 0,1 % et que la largeur du pic associé à la couche est celle d'une très bonne épitaxie.

## Revendications

1. Procédé pour déposer sur un substrat par épitaxie en phase liquide un composé ternaire cristallisant dans le même système que le substrat et répondant à la formule $A_xB_{n-x}C_m$ dans laquelle A, B et C sont des éléments de la classification périodique des éléments, n et m sont des nombres entiers et x est compris entre 0 et n, consistant à mettre en contact un bain d'épitaxie avec le substrat à revêtir, et à déposer sur celui-ci le composé ternaire $A_xB_{n-x}C_m$, caractérisé en ce que l'on prépare ledit bain d'épitaxie en portant l'un des éléments A ou B du composé ternaire et un excès du composé binaire solide stœchiométrique des deux autres éléments dudit composé ternaire à une température légèrement inférieure à celle du liquidus de la phase liquide de A, B et C en équilibre avec la phase solide $A_xB_{n-x}C_m$ et en ce que l'on effectue le dépôt à cette température.

2. Procédé selon la revendication 1, caractérisé en ce que l'on prépare le bain d'épitaxie en portant l'élément A et le composé binaire solide stœchiométrique de formule $B_nC_m$ en excès à ladite température.

3. Procédé selon la revendication 1, caractérisé en ce que l'on prépare ledit bain d'épitaxie en portant l'élément B et le composé binaire solide stœchiométrique de formule $A_nC_m$ en excès à ladite température.

4. Procédé selon l'une quelconque des revendications 1 à 3, caractérisé en ce que l'on réalise le dépôt en portant le substrat à la même température que le bain d'épitaxie.

5. Procédé selon l'une quelconque des revendications 1 à 4, caractérisé en ce que le composé ternaire est un composé du type III-V de formule $A_xB_{n-x}C_m$ dans laquelle n et m sont égaux à 1, ce composé étant choisi dans le groupe comprenant $Ga_xIn_{1-x}As$, $As_xSb_{1-x}Ga$, $As_xSb_{1-x}In$, $P_xSb_{1-x}In$ et $P_xSb_{1-x}Ga$.

6. Procédé selon l'une quelconque des revendications 1 à 4, caractérisé en ce que le composé ternaire est un composé du type II-VI de formule $A_xB_{n-x}C_m$ dans laquelle n et m sont égaux à 1, ce composé étant choisi parmi les composés suivants :
$Zn_xCd_{1-x}Se$, $Zn_xCd_{1-x}Te$, $Zn_xHg_{1-x}Te$, $Zn_xHg_{1-x}Se$, $Cd_xHg_{1-x}Se$, $Cd_xHg_{1-x}Te$, $Zn_xCd_{1-x}S$, $Zn_xCd_{1-x}Se$, $Zn_xCd_{1-x}Te$, $Zn_xHg_{1-x}S$, $S_xSe_{1-x}Zn$, $S_xTe_{1-x}Zn$, $S_xSe_{1-x}Cd$, $S_xTe_{1-x}Cd$, $Se_xTe_{1-x}Zn$, $Se_xTe_{1-x}Cd$ et $Se_xTe_{1-x}Hg$.

7. Procédé selon l'une quelconque des revendications 1 à 4, caractérisé en ce que le composé ternaire répond à la formule $In_{0,53}Ga_{0,47}As$.

8. Procédé selon la revendication 7, caractérisé en ce qu'il consiste :
a) à préparer un bain d'épitaxie en portant de l'indium et du GaAs à une température d'environ 495 °C,
b) à mettre en contact ledit bain avec le substrat à revêtir, et
c) à déposer sur ce substrat maintenu à la température de 495 °C le composé $In_{0,53}Ga_{0,47}As$.

9. Procédé selon l'une quelconque des revendications 7 et 8, caractérisé en ce que le substrat est constitué par de l'InP orienté (100).

## Claims

1. Process for the deposition on a substrate by epitaxial growth from liquid phase, a ternary compound crystallizing in the same system as the substrate, and having the formula $A_xB_{n-x}C_m$ in which A, B and C are elements of the periodic classification of the elements, n and m are integers, and x is between 0 and n, comprising contacting an epitaxial bath with the substrate to be coated, and in depositing thereon the ternary compound $A_xB_{n-x}C_m$, characterised in that said epitaxial bath is prepared from one of the elements A or B of the ternary compound, and an excess of a stoichiometric solid binary compound of the other two elements of said ternary compound at a temperature slightly below that of the liquidus of the liquid phase of A, B anc C in equilibrium with the solid phase $A_xB_{n-x}C_m$, and in that deposition is carried out at said temperature.

2. Process according to claim 1, characterised in the epitaxial bath containing element A and an excess of the solid stoichiometric binary compound of formula $B_nC_m$ is prepared at said temperature.

3. Process according to claim 1, characterised in that said epitaxial bath containing element B and an excess of the solid stoichiometric binary compound of formula $A_nC_m$ is prepared at said temperature.

4. Process according to any one of claims 1 to 3, characterised in that deposition is carried out by bringing the substrate to the same temperature as the epitaxial bath.

5. Process according to any one of claims 1 to 4, characterised in that the ternary compound is a compound of the type III-V of the formula $A_xB_{n-x}C_m$ in which n and m are 1, the compound being selected from the group comprising $Ga_xIn_{1-x}As$, $As_xSb_{1-x}Ga$, $As_xSb_{1-x}In$, $P_xSb_{1-x}In$ and $P_xSb_{1-x}Ga$.

6. Process according to any one of claims 1 to 4, characterised in that the ternary compound is a compound of the type II-VI of the formula $A_xB_{n-x}C_m$ in which m and n are equal to 1, said compound being selected from the following compounds :
$Zn_xCd_{1-x}Se$, $Zn_xCd_{1-x}Te$, $Zn_xHg_{1-x}Te$, $Zn_xHg_{1-x}Se$, $Cd_xHg_{1-x}Se$, $Cd_xHg_{1-x}Te$, $Zn_xCd_{1-x}S$, $Zn_xCd_{1-x}Se$, $Zn_xCd_{1-x}Te$, $Zn_xHg_{1-x}S$, $S_xSe_{1-x}Zn$, $S_xTe_{1-x}Zn$, $S_xSe_{1-x}Cd$, $S_xTe_{1-x}Cd$, $Se_xTe_{1-x}Zn$, $Se_xTe_{1-x}Cd$ and $Se_xTe_{1-x}Hg$.

7. Process according to any one of claims 1 to 4, characterised in that the ternary compound has the formula $In_{0,53}Ga_{0,47}As$.

8. Process according to claim 7, characterised in that it comprises :

a) preparing an epitaxial bath containing indium and GaAs at a temperature around 495 °C,

b) contacting said bath with the substrate to be coated, and

c) depositing the compound $In_{0,53}Ga_{0,47}As$ on the substrate held at a temperature of 495 °C,

9. Process according to either of claims 7 and 8, characterised in that the substrate comprises oriented InP (100).


**Patentansprüche**

1. Verfahren zum Aufbringen einer ternären Verbindung auf einen Substrat mittels Flüssigphasenepitaxie, wobei die Verbindung in demselben System wie das Substrat kristalisiert und die Formel $A_xB_{n-x}C_m$ erfüllt, in der A, B und C Elemente des periodischen Systems und n und m ganze Zahlen sind und x zwischen 0 und n liegt, wobei bei dem Verfahren ein Epitaxiebad mit dem zu überziehenden Substrat in Berührung gebracht und auf diesem die ternäre Verbindung $A_xB_{n-x}C_m$ aufgebracht wird, dadurch gekennzeichnet, daß man das Epitaxiebad dadurch herstellt, daß man eines der Elemente A oder B der ternären Verbindung und von der stoechiometrischen, festen Binärverbindung der zwei anderen Elemente der genannten ternären Verbindung im Überschuß auf eine Temperatur bringt, die etwas unterhalb derjenigen des Liquidus der Flüssigphase von A, B und C im Gleichgewicht mit der festen Phase $A_xB_{n-x}C_m$ liegt, und daß das Aufbringen bei dieser Temperatur durchgeführt wird.

2. Verfahren nach Anspruch 1, dadurch gekennzeichnet, daß man das Epitaxiebad dadurch herstellt, daß man das Element A und die feste stöchiometrische Binärverbindung $B_nC_m$ im Überschuß auf diese Temperatur bringt.

3. Verfahren nach Anspruch 1, dadurch gekennzeichnet, daß man das Epitaxiebad dadurch herstellt, daß man das Element B und die feste stoechiometrische Binärverbindung der Formel $A_nC_m$ im Überschuß auf die genannte Temperatur bringt.

4. Verfahren nach einem der Ansprüche 1 bis 3, dadurch gekennzeichnet, daß man das Aufbringen dadurch durchführt, daß man das Substrat auf dieselbe Temperatur wie das Epitaxiebad erwärmt.

5. Verfahren nach einem der Ansprüche 1 bis 4, dadurch gekennzeichnet, daß die ternäre Verbindung eine Verbindung der Art III-V der Formel $A_xB_{n-x}C_m$ ist, in der n und m gleich 1 sind, wobei diese Verbindung aus der Gruppe ausgewählt wird, die enthält $Ga_xIn_{1-x}As$, $As_xSb_{1-x}Ga$, $As_xSb_{1-x}In$, $P_xSb_{1-x}In$ und $P_xSb_{1-x}Ga$.

6. Verfahren nach einem der Ansprüche 1 bis 4, dadurch gekennzeichnet, daß die ternäre Verbindung eine Verbindung von der Art II-VI der Formel $A_xB_{n-x}C_m$ ist, in der n und m gleich 1 sind, wobei diese Verbindung aus den folgenden Verbindungen ausgewählt wird :

$Zn_xCd_{1-x}Se$, $Zn_xCd_{1-x}Te$, $Zn_xHg_{1-x}Te$, $Zn_xHg_{1-x}Se$, $Cd_xHg_{1-x}Se$, $Cd_xHg_{1-x}Te$, $Zn_xCd_{1-x}S$, $Zn_xCd_{1-x}Se$, $Zn_xCd_{1-x}Te$, $Zn_xHg_{1-x}S$, $S_xSe_{1-x}Zn$, $S_xTe_{1-x}Zn$, $S_xSe_{1-x}Cd$, $S_xTe_{1-x}Cd$, $Se_xTe_{1-x}Zn$, $Se_xTe_{1-x}Cd$ und $Se_xTe_{1-x}Hg$.

7. Verfahren nach einem der Ansprüche 1 bis 4, dadurch gekennzeichnet, daß die ternäre Verbindung der Formel $In_{0,53}Ga_{0,47}As$ genügt.

8. Verfahren nach Anspruch 7, dadurch gekennzeichnet, daß es darin besteht :

a) ein Epitaxiebad herzustellen, indem das Indium und das GaAs auf eine Temperatur von ungefähr 495 °C erwärmt werden,

b) das Bad mit dem zu bedeckenden Substrat in Berührung zu bringen und

c) auf dieses Substrat, welches bei der Temperatur von 495 °C gehalten wird, die Verbindung $In_{0,53}Ga_{0,47}As$ aufzu bringen.

9. Verfahren nach Anspruch 7 oder 8, dadurch gekennzeichnet, daß das Substrat von orientiertem (100) Indium gebildet wird.

**FIG.1**

**FIG.2a**

**FIG.2b**

12 secondes d'arc

Substrat In P

Couche In Ga As

**FIG.3**